# FASCICULE DE BREVET EUROPEEN

(11) **EP 1 501 099 B1**
(45) Date de publication et mention de la délivrance du brevet: **23.01.2008**
(21) Numéro de dépôt: 03016786.0
(22) Date de dépôt: 23.07.2003
(51) Int. Cl.: G11C 16/10, G11C 16/04, G11C 16/34

(54) **Tableau de cellules mémoires non volatiles à grille divisée adapté pour éviter les programmations parasites et procédé de programmation associé**
Nicht flüchtiges Speichermatrix mit Speicherzellen mit geteiltem Gate sowie Programmierverfahren zur Vermeidung von Störungen
Non volatile memory array with split gate cells and method for avoiding disturbance when programming

(43) Date de publication de la demande: 26.01.2005
(73) Titulaire: EM Microelectronic-Marin SA, 2074 Marin (CH)
(72) Inventeur: Marinelli, Filippo, 2000 Neuchâtel (CH); Harabech, Nadia, 2000 Neuchâtel (CH)
(74) Mandataire: Surmely, Gérard

(56) Documents cités:
- US-A1- 2002 167 844
- US-B1- 6 211 547
- US-B1- 6 285 593
- US-B1- 6 400 603

## Description

### DOMAINE TECHNIQUE

La présente invention concerne, de manière générale, un circuit intégré comprenant un tableau de cellules mémoires non volatiles à grille divisée, du type FLASH EEPROM, ayant une architecture en pages pour les opérations d'effacement et de programmation des cellules. Plus particulièrement, la présente invention concerne l'utilisation de tels architectures de tableaux mémoires pour des applications embarquées dans des cartes intelligentes en remplacement des mémoires non volatiles traditionnelles.

La présente invention concerne également un procédé de programmation d'une cellule mémoire d'un tel tableau.

### ARRIÈRE-PLAN TECHNOLOGIQUE

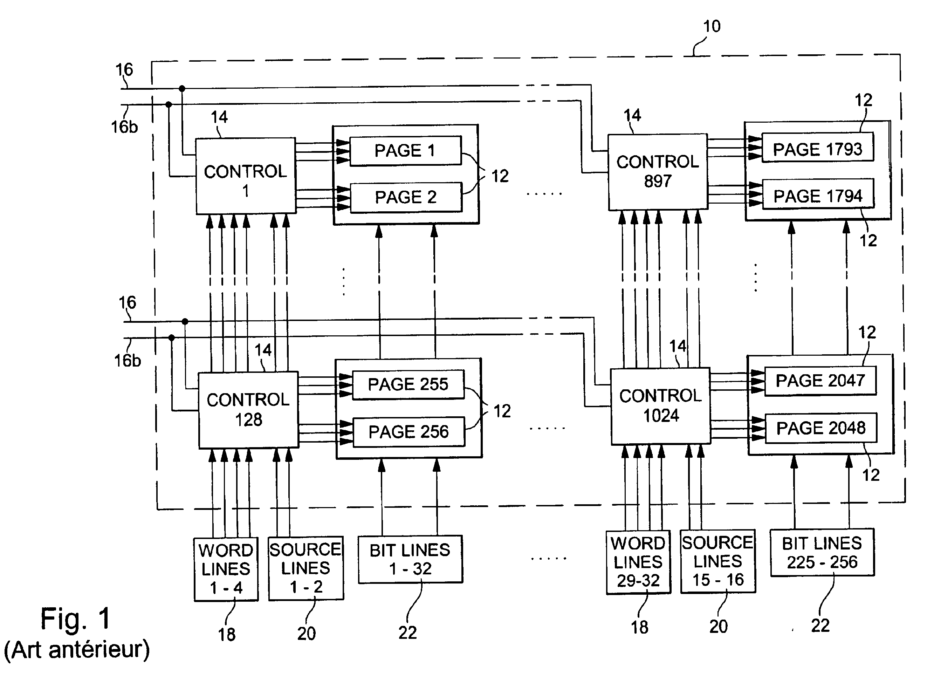

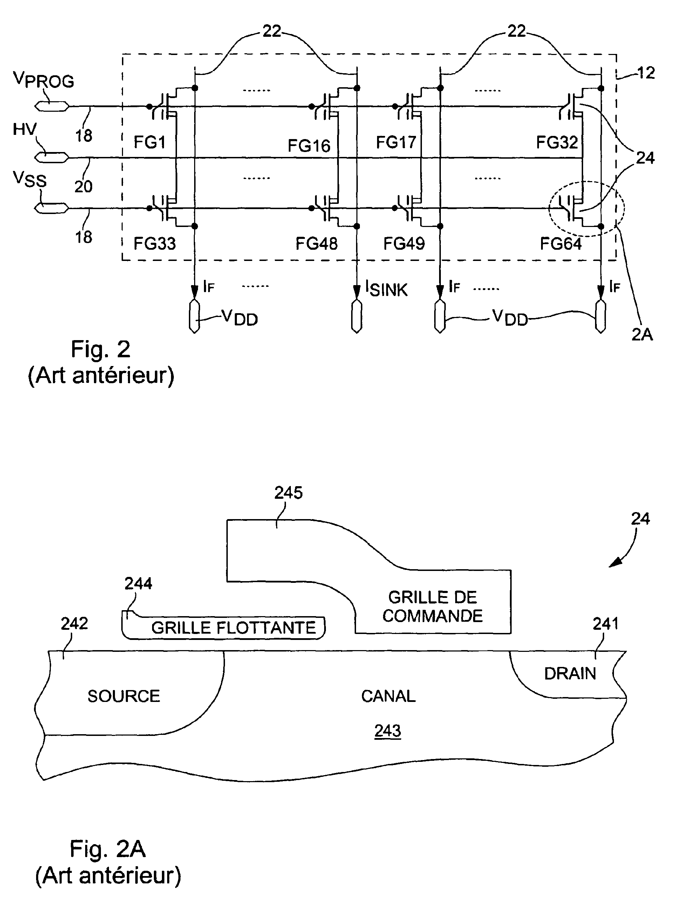

Des tableaux de cellules mémoires non volatiles à grille divisée, agencées selon une ou plusieurs rangées et colonnes et connectées électriquement entre elles par groupe de manière à former une ou plusieurs pages, sont déjà connus. Le document US 6,400,603, inclus ici par voie de référence, décrit par exemple un tableau répondant à la définition générale donnée ci-dessus. La figure 1 représente une architecture de tableau 10 organisé en 8 colonnes de 256 pages 12. A ces 8 colonnes correspondent 8 colonnes de circuits de commande 14 de 128 circuits de commande avec un circuit de commande pour deux pages. Les différents signaux de commande, qui ne seront pas détaillés ici, permettent d'effectuer des opérations classiques comme l'effacement d'une page ou la programmation de cellules d'une page. On notera néanmoins parmi ces signaux, les lignes de commande de rangées 16 et 16b, chacune étant connectée à tous les circuits de commande 14 de la rangée correspondante. Ces lignes de commande de rangées 16 et 16b ont pour fonction d'activer ou de désactiver une rangée de circuit de commande 14. On notera encore la présence des lignes de commande de mots 18, de lignes de commande de sources 20 et de lignes de commande de bits 22 pour commander chaque colonne de pages 12 et de circuits de commande 14.

La figure 2 représente le détail d'une page 12 d'un tableau selon la figure 1. Dans l'exemple représenté, chaque page 12 est formée par deux rangées de cellules 24 superposées.

Un agrandissement d'une cellule mémoire 24 utilisée est détaillée à la figure 2A. Chacune de ces cellules a une première région 241, appelée aussi drain, une deuxième région 242, appelée aussi source, espacée par rapport à la première région 241, une région canal 243 entre les première 241 et deuxième 242 régions, une grille flottante 244 et une grille de commande 245.

Ces cellules 24 contiennent une information binaire pouvant être modifiée soit par programmation, soit par effacement de la cellule. Lors de la programmation d'une telle cellule mémoire l'information binaire qu'elle contient peut prendre une première valeur déterminée, par exemple 0, par piégeage d'électrons chauds dans la grille flottante 244 du transistor. Lors d'une opération d'effacement de cette cellule, l'information binaire peut prendre une deuxième valeur déterminée, par exemple 1, par effet tunnel de Fowler-Nordheim qui permet le passage, sans ionisation, d'un électron piégé à partir de la grille flottante 244. Pour pouvoir effectuer de telles opérations en particulier de programmation, chaque cellule reçoit des premier, deuxième et troisième signaux de commande respectivement appliqué sur la grille de commande 245, sur la deuxième région 242, i.e. la source, et sur la première région 241, i.e. le drain, de la cellule 24 à programmer.

Comme il a été mentionné précédemment une page 12 est formé par un groupe de cellules 24 électriquement connectées entre elles. Cette connexion électrique entre les cellules d'une même page peut être notamment effectuée au moyen d'une ligne de commande de source 20 connectant toutes les sources 242 des cellules d'une page entre elles. C'est par l'intermédiaire de cette ligne de commande de source 20 que sont appliqués les deuxièmes signaux de commande sur les sources 242 des cellules d'une même page.

Les premiers signaux de commande qui sont appliqués sur la grille de commande 245 d'au moins une ou plusieurs cellules d'une même page, sont fournis par l'intermédiaire de lignes de commande de mots 18. Ces lignes de commande de mots connectent entre elles de préférence toutes les cellules 24 formant une même rangée (représentée horizontalement) à l'intérieur d'une page 12.

Les troisièmes signaux de commande sont appliqués sur le drain 241 des cellules mémoires d'une même colonne par l'intermédiaire de lignes de commande de bits 22. Ces lignes de commande de bits connectent de préférence toutes les cellules mémoires des pages formant une même colonne.

Pour programmer une cellule 24 déterminée parmi toutes les cellules d'une page 12, il est prévu d'appliquer les signaux de commande suivants :
pour la cellule à programmer, par exemple la cellule FG16 :
   - 1^{er} signal de commande :: V_{PROG}
   - 2^{ème} signal de commande :: HV
   - 3^{ème} signal de commande :: I_{SINK}
et pour les autres cellules ne devant pas être programmées :
   - 1^{er} signal de commande:: V_{PROG} ou V_{SS}
   - 2^{ème} signal de commande :: HV
   - 3^{ème} signal de commande :: I_{SINK} ou V_{DD}

V_{PROG} représente la tension de programmation appliquée à la grille de commande 245 de la cellule FG16 à programmer par l'intermédiaire de la ligne de commande de mots 18 correspondante. Par conséquent, toutes les cellules 24 de la page partageant la même ligne de commande de mots 18, soit les cellules FG1 à FG32, reçoivent sur leur grille de commande 245 le même signal de commande V_{PROG}.

V_{SS} représente une tension de référence, par exemple la masse, appliquée sur la grille de commande 245 de toutes les cellules 24 de la page ne partageant la même ligne de commande de mots 18 que celle de la cellule à programmer, soit les cellules FG33 à FG64.

I_{SINK} représente un courant de polarisation tiré depuis le drain 241 de la cellule FG16 à programmer par l'intermédiaire de la ligne de commande de bits 22 correspondant à cette cellule. Par conséquent, toutes les cellules 24 formant une colonne avec la cellule à programmer et partageant la même ligne de commande de bits 22, soit ici la cellule FG48, se voient appliquer le même signal de commande sur leur drain.

V_{DD} représente la tension d'alimentation de la mémoire appliquée au drain 241 de toutes les cellules ne partageant pas la même ligne de commande de bits 22, ce qui permet normalement d'éviter leur programmation.

HV représente une haute tension, par exemple 12 Volts, obtenue au moyen d'une pompe de charge comprenant le nombre d'étages amplificateurs adéquats. Cette haute tension est appliquée sur la source 242 de la cellule FG16 à programmer par l'intermédiaire de la ligne de commande de sources 20 de la page contenant cette cellule. Sachant que cette ligne de commande de sources connecte entre elles toutes les sources 242 des cellules 24 d'une même page, la haute tension HV est donc également appliquée sur la source de chacune des cellules de la page.

L'on remarque que pour programmer une cellule, il est important qu'un courant puisse traverser le canal 243 de cette cellule depuis la source 242 vers le drain 241. En revanche, pour éviter tous problèmes de programmation parasites, il est également important qu'aucun courant de fuites I_{F} ne circule au travers du canal des cellules ne devant pas être programmées.

Le type de mémoire sus-présentée est essentiellement destiné à des applications basse consommation, par exemple dans une carte intelligente ou pour un téléphone portable. Ainsi par exemple, pour les applications G.S.M (Global System for Mobile communications), il existe plusieurs standards en particulier concernant la tension d'alimentation applicable, qui peut être de 1.8V, 3V ou encore 5V.

Un tel exemple de mémoire est également connu dans l'art antérieur en particulier du document US 6.211.547.

Dans le cadre de la présente invention, il a été mis en évidence que pour une basse tension d'alimentation, i.e. proche de la tension de programmation V_{PROG}, la mémoire selon l'art antérieur détaillée ci-avant, présente dans une même page des programmations parasites de cellules partageant la même ligne de commande de mots 18 que celle utilisée par la cellule à programmer.

Si l'on considère à nouveau les figures 2 et 2A, lors de la programmation, par exemple, de la cellule FG16, les cellules FG1 à FG15 et les cellules FG17 à FG32 qui partagent toutes avec la cellule FG16 la même ligne de commande de mots 18, reçoivent sur leur grille de commande 245 la tension de programmation V_{PROG}. Dans ce cas, la différence de potentiel, d'une part, entre la source 242 et le drain 241 de ces régions est importante et, d'autre part, entre la grille de commande 245 et le drain 241 est faible, ce qui a pour effet de ne pas résister fortement au passage du courant de fuites I_{F} via le canal 243. Ces deux effets combinés ont pour résultat de présenter un risque important de programmations parasites des cellules 24 partageant la même ligne de commande de mots 18 pour une basse tension d'alimentation V_{DD} proche de la tension de programmation V_{PROG}.

L'inconvénient de telles programmations parasites réside non seulement dans les modifications non souhaitées des informations contenues dans la mémoire, mais également, dans la nécessité de limiter le nombre de programmations permises avant de devoir effectuer une opération d'effacement des pages modifiées et ce qui impose une réduction de leur taille.

### RÉSUMÉ DE L'INVENTION

Un but général de la présente invention est donc de proposer une solution permettant d'assurer une bonne fiabilité des informations contenues dans la mémoire tout en assurant une durée de vie raisonnable de fonctionnement de cette mémoire.

Dans cette optique, on vise en particulier à assurer pour une basse tension d'alimentation, une programmation efficace d'une cellule déterminée sans présenter de risques importants de programmations parasites des cellules ayant des connexions électriques communes avec la cellule à programmer et en particulier partageant la même ligne de commande de mots.

La présente invention a ainsi pour objet un circuit intégré comprenant un tableau de cellules mémoires non volatiles à grille divisée du type susmentionné dont les caractéristiques sont énoncées dans la revendication 1.

La présente invention a également pour objet un procédé de programmation des cellules mémoires d'un tel tableau.

Des modes de réalisation avantageux de la présente invention font l'objet des revendications dépendantes.

Il est ainsi proposé de pourvoir le circuit d'une logique de blocage délivrant une tension de blocage strictement supérieure à la basse tension d'alimentation, appliquée sur les drain des cellules recevant le même premier signal de commande que celui appliqué à la cellule à programmer.

L'invention concerne également un circuit intégré comprenant des moyens amplificateurs de tension connectés à la logique de blocage pour délivrer la première tension de blocage strictement supérieure à la basse tension d'alimentation.

Ces moyens amplificateurs de tension peuvent être, par exemple, soit un doubleur de tension intégré au tableau, soit une source de haute tension externe au tableau, du type pompe de charges, ou avantageusement au moins un étage de la pompe de charge utilisée pour délivrer la haute tension aux sources des cellules.

### BRÈVE DESCRIPTION DES DESSINS

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :
- la figure 1, déjà décrite, montre un architecture en pages d'un tableau de cellules mémoires selon l'art antérieur ;
- les figures 2 et 2A, déjà décrite, montrent respectivement le détail d'une page du tableau de la figure 1 et un agrandissement d'une cellule mémoire à grille divisée de la figure 2 ;
- les figures 3A et 3B montrent quatre cellules voisines avec le détail des signaux appliqués respectivement selon des premier et deuxième variantes de programmation ;
les figures 4A et 4B montrent l'intégration de moyens amplificateurs selon des premier et deuxième modes de réalisation de l'invention.

### DESCRIPTION DE MODES DE RÉALISATION PRÉFÉRÉS

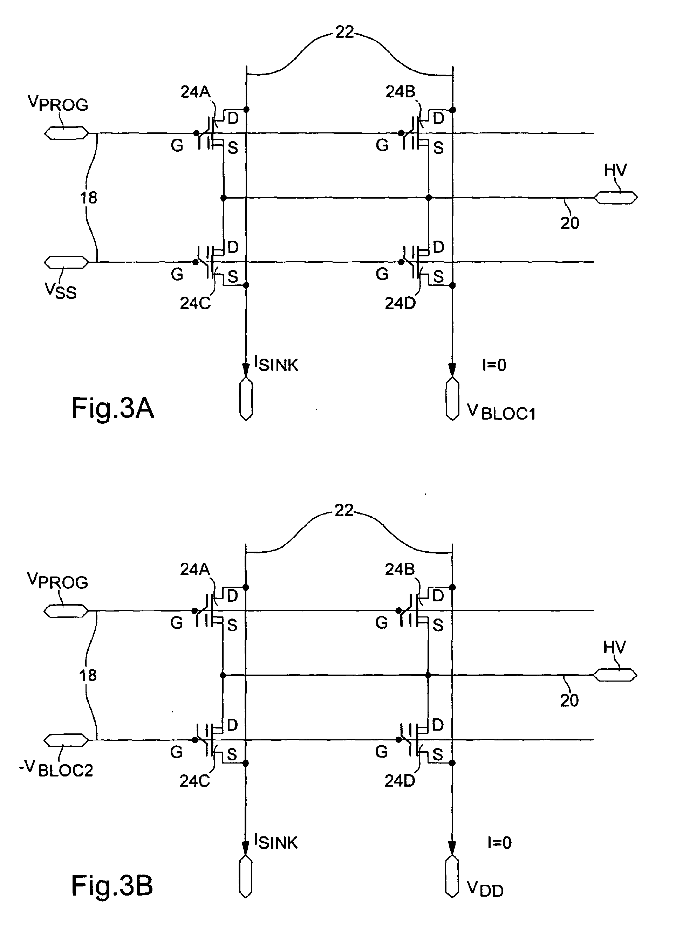

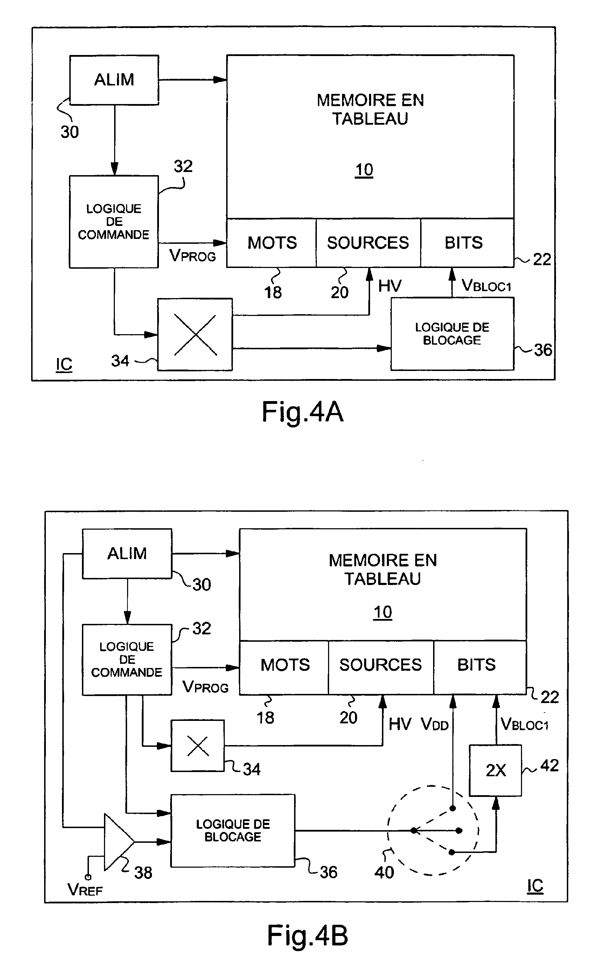

Dans la suite de la présente description, on décrira dans un premier temps des modes de programmation selon l'invention (figures 3A et 3B) et dans un deuxième temps l'intégration d'un tel tableau dans un circuit intégré (figures 4A et 4B).

A titre d'exemple non limitatif, la figure 3A montre selon un premier mode de programmation, un agrandissement d'une partie du tableau mémoire présenté à la figure 1 et plus particulièrement d'une page 12 représentée à la figure 2. Sur cet agrandissement, quatre cellules mémoires 24 à grille divisée d'une même page sont représentées. Ces cellules 24A, 24B, 24C et 24D sont similaires à celle représentée à la figure 2A. Elles ont chacune une première région correspondant à leur drain D, une deuxième région correspondant à leur source S et une troisième région correspondant à leur grille de commande G. Les grilles de commande G reçoivent des premiers signaux de commande (V_{PROG} ou V_{SS}) via des lignes de commande de mots 18. Les sources S reçoivent des deuxièmes signaux de commande (HV) via une ligne de commande de sources 20. Et les drains D reçoivent des troisièmes signaux de commande (I_{SINK} ou V_{BLOC1}) via des lignes de commande de bits 22.

Dans l'exemple représenté, les quatre cellules 24A à 24D sont connectées entre elles de la manière suivante. Les quatre cellules appartiennent à la même page et partagent donc la même ligne de commande de sources 20. Néanmoins, il est tout à fait envisageable que ces cellules ne partagent pas physiquement la même ligne de commande de sources, mais que chacune des cellules formant une page reçoivent, indépendamment des autres cellules formant cette page, une haute tension comme deuxième signal de commande par l'intermédiaire de lignes de commande sources distinctes. Les cellules 24A et 24B, respectivement 24C et 24D, situées sur une même rangée partagent une même ligne de commande de mots 18. Les cellules 24A et 24C, respectivement 24B et 24D, situées sur une même colonne partagent une même ligne de commande de bits 22.

Toujours dans le cadre de l'exemple de la figure 3A, il est prévu de programmer la cellule 24A, tout en évitant les programmations parasites en particulier sur la cellule 24B pour une basse tension d'alimentation de la mémoire. Afin de programmer la cellule 24A, il est appliqué une tension dite de programmation V_{PROG}, légèrement inférieure ou sensiblement égale à la basse tension d'alimentation V_{DD}, sur la grille de commande de la cellule 24A via la ligne de commande de mots 18 correspondant à cette cellule. Il est également appliqué une haute tension HV sur la source de cette cellule 24A via la ligne de commande de sources 20 et un courant de polarisation I_{SINK} est tiré sur le drain D de cette cellule 24A via la ligne de commande de bits 22 correspondant à cette cellule.

La cellule 24B reçoit la tension de programmation V_{PROG} sur sa grille de commande car elle partage la même ligne de commande de mots 18 que la cellule 24A à programmer et la haute tension HV sur sa source, car elle partage la même ligne de commande de sources 20 que la cellule 24A. En revanche le troisième signal de commande appliqué via la ligne de commande de bits 22 est libre car la cellule 24B ne partage pas la même ligne de commande de bits 22 que la cellule 24A à programmer.

Comme cela a été mis en évidence dans le cadre de la présente invention, afin d'éviter une programmation parasite sur la cellule 24B, une tension de blocage V_{BLOC1} strictement supérieure à la basse tension d'alimentation V_{DD} de la mémoire est appliquée sur le drain de cette cellule 24B via la ligne de commande de bits 22 correspondant à cette cellule 24B. Avantageusement, cette première tension de blocage V_{BLOC1} est au moins deux fois supérieure à la basse tension d'alimentation V_{DD}. Ainsi, le canal conducteur entre les première et deuxième régions (drain et source) de la cellule 24B n'a quasiment aucune probabilité de se former et donc aucun courant de fuite I_{F} significatif ne peut circuler au travers de ce canal de manière à programmer involontairement cette cellule.

On notera que les cellules 24C et 24D ont leurs grilles de commande respectives connectées à une même ligne de commande de mots 18 différente de celle connectée à la grille de commande de la cellule 24A à programmer. Ainsi, il est possible d'appliquer comme premier signal de commande, une tension de référence V_{SS}, comme par exemple la masse, assurant ainsi la non-programmation de ces cellules.

La figure 3B montre, également à titre d'exemple, le même agrandissement que celui de la figure 3A selon un deuxième mode de programmation. Les références numériques sont les mêmes que celles utilisées à la figure 3A. Dans le cadre de la présente invention, il a été également mis en évidence une autre solution afin d'éviter la programmation parasite des cellules partageant la même ligne de commande de mots 18 que la ou ies cellules à programmer. Cette autre solution consiste, dans l'exemple représenté, à abaisser la tension de programmation V_{PROG} de la cellule 24A à programmer, cette tension de programmation V_{PROG} étant alors nettement inférieure à la basse tension d'alimentation V_{DD} de la mémoire. On notera néanmoins que cette tension de programmation doit rester suffisamment élevée de manière à rendre le canal de la cellule à programmer conducteur. En conséquence, le courant de polarisation I_{SINK} tiré depuis le drain de la cellule 24A à programmer via la ligne de commande de bits 22 entraîne une tension réduite sur le drain 241 de la cellule 24C, ce qui augmente la différence de potentiel entre la source 242 et le drain de 241 de cette cellule 24C, augmentant ainsi son courant de fuite I_{F}. Il résulte de cela, un risque accru de programmation parasite des cellules partageant cette même ligne de commande de bits 22, soit la cellule 24C dans cet exemple. Pour remédier à cela, tout en empêchant toujours les problèmes de programmation parasite des cellules partageant la même ligne de commande de mots 18 que la cellule à programmer, il est prévu, à la différence du premier mode, d'appliquer d'une part la basse tension d'alimentation V_{DD} sur les drains des cellules 24B et 24D via la ligne de commande de bits 22 et, d'autre part, une tension de blocage négative -V_{BLOC2} sur la ligne de commande de mots 18 des cellules 24C et 24D. Ainsi, ni le canal de la cellule 24B, ni celui de la cellule 24C ne sont traversés par des courants de fuites I_{F}.

La figure 4A montre l'intégration d'un tableau mémoire tel que défini précédemment dans un circuit intégré, selon un premier mode de réalisation de l'invention. Le circuit intégré IC est alimenté par une source d'alimentation 30 basse tension V_{DD} externe ou interne. Le circuit comprend notamment le tableau mémoire 10 tel qu'il a été défini précédemment, c'est-à-dire les cellules mémoires disposées en rangées et en colonnes auxquelles il faut ajouter la logique de commande 32 des cellules délivrant les différents signaux de commande via des premières, deuxièmes et troisièmes lignes de commande, respectivement de mots 18, de sources 20 et de bits 22 ainsi que des moyens amplificateurs de tension, comme par exemple une pompe de charge 34 permettant de délivrer une haute tension HV fournie aux sources des cellules mémoires comprenant une cellule à programmer via la ligne de commande de sources 20. Le circuit comprend en outre une logique de blocage 36 pour délivrer un signal de blocage V_{BLOC1} applicable sur les drains des cellules partageant la même ligne de commande de mots 18 qu'une cellule à programmer via la ligne de commande de bits 22 selon la première variante de programmation sus-présentée. Cette logique de blocage 36 est connectée à des moyens amplificateurs de tension externes ou internes à la mémoire. Avantageusement, il est prévu d'utiliser la haute tension HV fournie par la pompe de charge 34, soit en dérivant la tension en sortie d'un étage de la pompe de charge, soit en prévoyant un pont diviseur de tension, non représenté, entre la sortie de la pompe de charge 34 et les lignes de commande de bits 22 destinées à recevoir le signal de blocage V_{BLOC1}.

Si l'on se réfère à la deuxième variante de programmation sus-présentée, pour obtenir le signal négatif de blocage - V_{BLOC2} applicable sur les grilles de commande des cellules partageant la même ligne de bits 22 qu'une cellule à programmer via la ligne de commande de mots 18 correspondante, il suffira par exemple de pourvoir le circuit intégré IC avec des moyens inverseurs de tension, ces éléments n'étant pas représentés sur la figure 4A.

La figure 4B représente l'intégration d'un tableau 10 tel que défini précédemment dans un circuit intégré IC selon un deuxième mode de réalisation de l'invention. Les éléments communs avec la figure 4A gardent les mêmes références numériques. Dans ce deuxième mode de réalisation, il est avantageusement prévu de pouvoir alimenter le circuit intégré IC avec n'importe quelle tension alimentation V_{DD}, de préférence standard, fournissant au minimum une basse tension d'alimentation prédéterminée V_{REF}, appelée ci-après « tension de référence ».

On retrouve le tableau 10 de cellules mémoires avec sa logique de commande 32 et ses différentes lignes de commande de mots 18, de sources 20, et de bits 22 associées. Comme dans le premier mode, une pompe de charge 34 peut être utilisée pour générer la haute tension HV fournie aux sources des cellules d'une même page dont il est prévu de programmer au moins une cellule.

Selon ce deuxième mode appliqué à la première variante de programmation, il est prévu additionnellement des moyens de comparaison 38 de la tension d'alimentation V_{DD} fournie avec la tension d'alimentation minimum ou tension de référence V_{REF} pour faire fonctionner le circuit intégré IC. Si la tension d'alimentation V_{DD} est strictement supérieure à la tension de référence V_{REF}, des moyens d'activation, comme par exemple un interrupteur 40, sont positionnés de manière à pouvoir fournir directement la tension d'alimentation V_{DD} aux drains des cellules ne devant pas être programmées et partageant la même ligne de commande de mots 18 qu'une cellule à programmer, via les lignes de commande de bits 22 correspondant à ces cellules. Si la tension d'alimentation V_{DD} est sensiblement égale à la tension de référence V_{REF}, les moyens d'activation 40 sont positionnés de manière à ce que la tension d'alimentation V_{DD} soit amplifiée au travers de moyens amplificateurs de tension, comme par exemple, un doubleur de tension 42 délivrant en sortie une tension de blocage V_{BLOC1} strictement supérieure à la tension d'alimentation V_{DD}, applicable aux drains des cellules ne devant pas être programmées et partageant la même ligne de commande de mots 18 qu'une cellule à programmer, via les lignes de commande de bits 22 correspondant à ces cellules.

De la même manière que pour le premier mode de réalisation, l'adaptation du deuxième mode de réalisation à la deuxième variante de programmation peut être simplement réalisée en remplaçant le doubleur de tension 42 par des moyens pour générer une tension de blocage négative -V_{BLOC2}, comme par exemple des moyens inverseurs de tension, non représentés.

On comprendra que diverses modifications et/ou améliorations évidentes pour l'homme du métier peuvent être apportées aux différentes variantes de programmation ainsi qu'aux différents modes de réalisation décrits dans la présente description sans sortir du cadre de l'invention défini par les revendications annexées. En particulier, concernant les moyens amplificateurs de tension utilisés pour obtenir les première et deuxième tensions de blocage V_{BLOC1} et -V_{BLOC2}, ainsi que l'architecture et la connectique entre les différentes cellules mémoire à grille divisée formant le tableau. Ainsi, par exemple les tensions de blocage V_{BLOC1} et -V_{BLOC2} peuvent être fournies aux moyens de blocage depuis une unité externe au circuit intégré contenant le tableau de cellules mémoires. De même la haute tension HV appliquée aux sources des cellules mémoires via la ligne de commande de sources peut être fournie par une unité externe au circuit intégré.

On notera enfin que les notions de rangée et de colonne peuvent être interverties sans changer l'architecture du tableau mémoire.

## Revendications

1. Circuit intégré (IC) comprenant un tableau (10) de cellules mémoires (24) non volatile à grille divisée, alimenté par une source d'alimentation (30) basse tension (V_{DD}), lesdites cellules étant agencées selon une ou plusieurs rangées et colonnes et connectées électriquement entre elles par groupe de manière à former une ou plusieurs pages (12), chacune des cellules ayant une première région (241), une deuxième région (242) espacée par rapport à la première région, une région canal (243) entre les première et deuxième régions, une grille flottante (244) et une grille de commande (245), le tableau étant commandé en particulier par :
- une pluralité de premières lignes de commande (18), chacune de ces premières lignes de commande étant connectée à la grille de commande d'au moins une ou plusieurs cellules d'une même page ;
- une pluralité de deuxièmes lignes de commande (20), chacune de ces deuxièmes lignes de commande étant connectée à la deuxième région de l'ensemble des cellules mémoires d'une même page ;
- une pluralité de troisièmes lignes de commande (22), chacune de ces troisièmes lignes de commande étant connectée à ladite première région des cellules mémoires d'une même colonne ;
- une logique de commande (32) délivrant une tension de programmation (V_{PROG}) définie, sensiblement égale à la basse tension d'alimentation (V_{DD}) et appliquée sur une grille de commande d'au moins une cellule à programmer par l'intermédiaire de la première ligne de commande correspondant à cette cellule; et **caractérisé en ce que** le circuit comprend en outre :
- une logique de blocage (36) délivrant une première tension de blocage (V_{BLOC1}) strictement supérieure à ladite basse tension d'alimentation, appliquée sur les premières régions des cellules connectées à la même première ligne de commande que celle connectée à ladite cellule à programmer, par l'intermédiaire des troisièmes lignes de commande correspondant à ces cellules.

2. Circuit intégré selon la revendication 1, **caractérisé en ce que** le circuit comprend en outre des moyens amplificateurs de tension (34 ; 42) connectés à la logique de blocage pour délivrer la première tension de blocage strictement supérieure à la basse tension d'alimentation.

3. Circuit intégré selon la revendication 2, **caractérisé en ce que** les moyens amplificateurs sont formés par un doubleur de tension (42).

4. Circuit intégré selon la revendication 2, comprenant une pompe de charge (34) externe au tableau pour délivrer une haute tension (HV) appliquée sur la deuxième région de la cellule à programmer par l'intermédiaire de la deuxième ligne de commande correspondant à cette cellule, **caractérisé en ce que** les moyens amplificateurs sont formés par au moins un étage de ladite pompe de charge ;

5. Circuit intégré selon l'une des revendications 2 à 4, alimenté par une source d'alimentation (30) ayant une tension d'alimentation (V_{DD}) pouvant être supérieure à une tension de référence (V_{REF}) minimum, **caractérisé en ce que** la logique de blocage comprend en outre des moyens d'activation (40) pour activer lesdits moyens amplificateurs (42) uniquement pour une tension d'alimentation sensiblement égale à la tension de référence.

6. Circuit intégré selon la revendication 1, **caractérisé en ce que** ladite première tension de blocage est fournie par une unité externe au dit circuit.

7. Circuit intégré comprenant un tableau (10) de cellules mémoires (24) non volatile à grille divisée, alimenté par une source d'alimentation (30), lesdites cellules étant agencées selon une ou plusieurs rangées et colonnes et connectées électriquement entre elles par groupe de manière à former une ou plusieurs pages (12), chacune des cellules ayant une première région (241), une deuxième région (242) espacée par rapport à la première région, une région canal (243) entre les première et deuxième régions, une grille flottante (244) et une grille de commande (245), le tableau étant commandé en particulier par :
- une pluralité de premières lignes de commande (18), chacune de ces premières lignes de commande étant connectée à la grille de commande d'au moins une ou plusieurs cellules d'une même page ;
- une pluralité de deuxièmes lignes de commande (20), chacune de ces deuxièmes lignes de commande étant connectée à la deuxième région de l'ensemble des cellules mémoires d'une même page ;
- une pluralité de troisièmes lignes de commande (22), chacune de ces troisièmes lignes de commande étant connectée à ladite première région des cellules mémoires d'une même colonne ;
- une logique de commande (32) délivrant une tension de programmation (V_{PROG}) définie, strictement inférieure à une tension d'alimentation (V_{DD}), appliquée sur une grille de commande d'au moins une cellule à programmer par l'intermédiaire de la première ligne de commande correspondant à cette cellule;
et **caractérisé en ce que** le circuit comprend en outre :
- une logique de blocage (36) délivrant une deuxième tension de blocage (-V_{BLOC2}) négative appliquée sur les grilles de commande des cellules connectées à la même troisième ligne de commande que celle connectée à ladite cellule à programmer, par l'intermédiaire des premières lignes de commande correspondant à ces cellules.

8. Circuit intégré selon la revendication 7, **caractérisé en ce que** ladite deuxième tension de blocage est fournie par une unité externe au dit circuit.

9. Procédé de programmation d'une cellule mémoire d'un tableau du circuit selon la revendication 2, comprenant en particulier les opérations consistant à :
- appliquer une tension de programmation (V_{PROG}) définie, sensiblement égale à la basse tension d'alimentation (V_{DD}), sur la grille de commande (245) de la cellule (24A) à programmer par l'intermédiaire de la première ligne de commande (18) correspondant à cette cellule ;
- amplifier ladite basse tension d'alimentation pour générer une première tension de blocage (V_{BLOC1}) strictement supérieure à ladite basse tension d'alimentation ; et
- appliquer ladite première tension de blocage sur les premières régions (241) des cellules (24B) partageant la même première ligne de commande que celle connectée à ladite cellule à programmer, par l'intermédiaire des troisièmes lignes de commande (22) correspondant à ces cellules.

10. Procédé de programmation d'une cellule mémoire selon la revendication 9, pour lequel le tableau peut être alimenté par une source d'alimentation ayant une tension d'alimentation supérieure à une tension de référence (V_{REF}) minimum, le procédé comprenant une opération préliminaire consistant à :
- activer lesdits moyens amplificateurs (34 ; 42) uniquement pour une tension d'alimentation reçue sensiblement égale à la tension de référence.

11. Procédé de programmation d'une cellule mémoire d'un tableau du circuit selon la revendication 8, comprenant en particulier les opérations consistant à :
- appliquer une tension de programmation (V_{PROG}) définie, strictement inférieure à la tension d'alimentation (V_{DD}), sur la grille de commande (245) de la cellule (24A) à programmer par l'intermédiaire de la première ligne de commande (18) correspondant à cette cellule;
- générer une deuxième tension de blocage (-V_{BLOC2}) négative;
- appliquer cette deuxième tension de blocage négative, sur les grilles de commande des cellules (24C) partageant la même troisième ligne de commande (22) que celle connectée à ladite cellule à programmer, par l'intermédiaire des premiers lignes de commande (18) correspondant à ces cellules; et
- appliquer la basse tension d'alimentation sur les cellules partageant la même première ligne de commande que la cellule à programmer, par l'intermédiaire de la troisième ligne de commande de ces cellules.

## Claims

1. Integrated circuit (IC) comprising an array (10) of split-gate non-volatile memory cells (24) supplied with power at a low voltage (V_{DD}) by a power supply (30), said cells being arranged in one or more rows and columns and electrically interconnected in groups to form one or more pages (12), each of the cells having a first region (241), a second region spaced from the first region, a channel region (243) between the first and second regions, a floating gate (244), and a control gate (245), the array being controlled in particular by :
- first control lines (18) each connected to the control gate of one or more cells of the same page;
- second control lines (20) each connected to the second region of all of the memory cells of the same page;
- third control lines (22) each connected to said first region of the memory cells of the same column; wherein
- a control logic (32) delivering a defined programming voltage (V_{PROG}) that is close or substantially equal to the low power supply voltage (V_{DD}) that is applied to a control gate of at least one cell that is to be programmed via the first control line corresponding to that cell,
and **characterized in that** it further comprises:
- a blocking logic (36) delivering a first blocking voltage (V_{BLOC1}) that is greater than said low power supply voltage and is applied to the first regions of the cells connected to the same first control line as said cell that is to be programmed via third control lines corresponding to those cells.

2. Integrated circuit according to claim 1, **characterized in that** the circuit further comprises voltage amplifier means (34; 42) connected to the blocking logic to deliver the first blocking voltage greater than the low power supply voltage.

3. Integrated circuit according to claim 2, **characterized in that** the amplifier means comprise a voltage doubler (42).

4. Integrated circuit according to claim 2, comprising a charge pump (34) external to the array for delivering a high voltage (HV) that is applied to the second region of the cell that is to be programmed via the second control line corresponding to that cell, **characterized in that** the amplifier means comprise at least one stage of said charge pump.

5. Integrated circuit according to any of claims 2 to 4, supplied with power by a power supply (30) at a power supply voltage (V_{DD}) that may be greater than a minimum reference voltage (V_{REF}), **characterized in that** the blocking logic further comprises activation means (40) for activating said amplifier means (42) only for a power supply voltage substantially equal to the reference voltage.

6. Integrated circuit according to claim 1, **characterized in that** said first blocking voltage is supplied by a unit external to said circuit.

7. Integrated circuit comprising an array (10) of split-gate non-volatile memory cells (24) supplied with power by a power supply (30), said cells being arranged in one or more rows and columns and electrically interconnected in groups to form one or more pages (12), each of the cells having a first region (241), a second region (242) spaced from the first region, a channel region (243) between the first and second regions, a floating gate (244), and a control gate (245), the array being controlled in particular by :
- first control lines (18) each connected to the control gate of one or more cells of the same page;
- second control lines (20) each connected to the second region of all of the memory cells of the same page;
- third control lines (22) each connected to said first region of the memory cells of the same column; wherein
- a control logic (32) delivering a defined programming voltage (V_{PROG}) that is less than the supply voltage (V_{DD}) that is applied to a control gate of at least one cell that is to be programmed via the first control line corresponding to that cell,
and **characterized in that** the circuit further comprises:
- a blocking logic (36) delivering a negative second blocking voltage (-V_{BLOC2}) that is applied to the control gate of the cell connected to the same third control line as said cell that is to be programmed via first control lines corresponding to those cells.

8. Integrated circuit according to claim 7, **characterized in that** said second blocking voltage is supplied by a unit external to said circuit.

9. Method of programming a memory cell of an array of the circuit according to claim 2, comprising in particular:
- applying a defined programming voltage (V_{PROG}) that is close or substantially equal to the low power supply voltage (V_{DD}) to the control gate (245) of the cell (24A) that is to be programmed via the first control line (18) corresponding to that cell;
- amplifying said low power supply voltage to generate a first blocking voltage (V_{BLOC1}) that is greater than said low power supply voltage; and
- applying said first blocking voltage to the first regions (241) of cells (24B) sharing the same first control line as said cell that is to be programmed via third control lines (22) corresponding to those cells.

10. Method of programming a memory cell according to claim 9 of programming a memory cell, wherein the array may be supplied with power by a power supply having a power supply voltage that is greater than a minimum reference voltage (V_{REF}), the method comprising a preliminary operation of:
- activating said amplifier means (34; 42) only for a received power supply voltage that is substantially equal to the reference voltage (V_{REF}).

11. Method of programming a memory cell of an array of the circuit according to claim 8, comprising in particular:
- applying a defined programming voltage (V_{PROG}) that is less than the supply voltage (V_{DD}) to the control gate (245) of the cell (24A) that is to be programmed via the first control line (18) corresponding to that cell;
- generating a negative second blocking voltage (-V_{BLOC2}),
- applying this negative second blocking voltage to the control gates of the cells (24C) sharing the same third control line (22) as said cell that is to be programmed via first control lines (18) corresponding to those cell; and
- applying the low supply voltage to the cells receiving a high voltage on their second control lines sharing the same first control lines as said cell that is to be programmed via the third control line of those cells.

## Patentansprüche

1. Integrierte Schaltung (IC), die eine Matrix (10) aus nichtflüchtigen Speicherzellen (24) mit geteiltem Gate umfasst, die durch eine Niederspannungs-Versorgungsquelle (V_{DD}, 30) versorgt wird, wobei die Zellen in einer oder in mehreren Reihen und Spalten angeordnet und gruppenweise miteinander elektrisch verbunden sind, derart, dass eine oder mehrere Seiten (12) gebildet werden, wobei jede der Zellen einen ersten Bereich (241), einen in Bezug auf den ersten Bereich beabstandeten zweiten Bereich (242), einen Kanalbereich (243) zwischen dem ersten und dem zweiten Bereich, ein schwebendes Gate (244) und ein Steuergate (245) besitzt, wobei die Matrix insbesondere gesteuert wird durch:
- mehrere erste Steuerleitungen (18), wovon jede mit dem Steuergate wenigstens einer oder mehrerer Zellen derselben Seite verbunden ist;
- mehrere zweite Steuerleitungen (20), wovon jede mit dem zweiten Bereich der Gesamtheit der Speicherzellen derselben Seite verbunden ist;
- mehrere dritte Steuerleitungen (22), wovon jede mit dem ersten Bereich der Speicherzellen derselben Spalte verbunden ist;
- eine Steuerlogik (32), die eine definierte Programmierspannung (V_{PROG}) liefert, die im Wesentlichen gleich der Versorgungsniederspannung (V_{DD}) ist und an ein Steuergate wenigstens einer zu programmierenden Zelle über die dieser Zelle entsprechende erste Steuerleitung angelegt wird;
und **dadurch gekennzeichnet, dass** die Schaltung ferner umfaßt:
- eine Sperrlogik (36), die eine erste Sperrspannung (V_{BLOC1}) liefert, die strikt größer als die Versorgungsniederspannung ist, die an die ersten Bereiche von Zellen angelegt wird, die mit derselben ersten Steuerleitung wie jene, die mit der zu programmierenden Zelle verbunden ist, über dritte Steuerleitungen, die diesen Zellen entsprechen, verbunden sind.

2. Integrierte Schaltung nach Anspruch 1, **dadurch gekennzeichnet, dass** die Schaltung außerdem Spannungsverstärkermittel (34; 42) enthält, die mit der Sperrlogik verbunden sind, um die erste Sperrspannung, die strikt größer als die Versorgungsniederspannung ist, zu liefern.

3. Integrierte Schaltung nach Anspruch 2, **dadurch gekennzeichnet, dass** die Verstärkermittel durch einen Spannungsverdoppler (42) gebildet sind.

4. Integrierte Schaltung nach Anspruch 2, die eine Ladungspumpe (34) außerhalb der Matrix umfasst, um eine hohe Spannung (HV) zu liefern, die an den zweiten Bereich der zu programmierenden Zelle über die zweite Steuerleitung, die dieser Zelle entspricht, angelegt wird, **dadurch gekennzeichnet, dass** die Verstärkermittel durch wenigstens eine Stufe der Ladungspumpe gebildet sind.

5. Integrierte Schaltung nach einem der Ansprüche 2 bis 4, die durch eine Versorgungsquelle (30) versorgt wird, die eine Versorgungsspannung (V_{DD}) besitzt, die größer als eine minimale Referenzspannung (V_{REF}) sein kann, **dadurch gekennzeichnet, dass** die Sperrlogik außerdem Aktivierungsmittel (40) umfasst, um die Verstärkermittel (42) ausschließlich für eine Versorgungsspannung zu aktivieren, die im Wesentlichen gleich der Referenzspannung ist.

6. Integrierte Schaltung nach Anspruch 1, **dadurch gekennzeichnet, dass** die erste Sperrspannung von einer Einheit außerhalb dieser Schaltung geliefert wird.

7. Integrierte Schaltung, die eine Matrix (10) aus nichtflüchtigen Speicherzellen (24) mit geteiltem Gate umfasst und durch eine Versorgungsquelle (30) versorgt wird, wobei die Zellen in einer oder in mehreren Reihen und Spalten angeordnet sind und gruppenweise miteinander elektrisch verbunden sind, derart, dass eine oder mehrere Seiten (12) gebildet werden, wobei jede der Zellen einen ersten Bereich (241), einen in Bezug auf den ersten Bereich beabstandeten zweiten Bereich (242), einen Kanalbereich (243) zwischen dem ersten und dem zweiten Bereich, ein schwebendes Gate (244) und ein Steuergate (245) enthält, wobei die Matrix insbesondere gesteuert wird durch:
- mehrere erste Steuerleitungen (18), wovon jede mit dem Steuergate wenigstens einer oder mehrerer Zellen derselben Seite verbunden ist;
- mehrere zweite Steuerleitungen (20), wovon jede mit dem zweiten Bereich der Gesamtheit von Speicherzellen derselben Seite verbunden ist;
- mehrere dritte Steuerleitungen (22), wovon jede mit dem ersten Bereich der Speicherzellen derselben Spalte verbunden ist;
- eine Steuerlogik (32), die eine definierte Programmierspannung (V_{PROG}) liefert, die strikt kleiner als eine Versorgungsspannung (V_{DD}) ist, die an ein Steuergate wenigstens einer zu programmierenden Zelle über die dieser Zelle entsprechende erste Steuerleitung angelegt wird;
und **dadurch gekennzeichnet, dass** die Schaltung außerdem umfasst:
- eine Sperrlogik (36), die eine zweite, negative Sperrspannung (-V_{BLOC2}) liefert, die an die Steuergates von Zellen angelegt wird, die mit derselben dritten Steuerleitung wie jene, die mit der zu programmierenden Zelle verbunden ist, über erste Steuerleitungen, die diesen Zellen entsprechen, verbunden sind.

8. Integrierte Schaltung nach Anspruch 7, **dadurch gekennzeichnet, dass** die zweite Sperrspannung durch eine Einheit außerhalb der Schaltung geliefert wird.

9. Verfahren zum Programmieren einer Speicherzelle einer Matrix der Schaltung nach Anspruch 2, das insbesondere die Operationen umfasst, die darin bestehen:
- eine definierte Programmierspannung (V_{PROG}), die im Wesentlichen gleich der Versorgungsniederspannung (V_{DD}) ist, an das Steuergate (245) der zu programmierenden Zelle (24A) über die erste Steuerleitung (18), die dieser Zelle entspricht, anzulegen;
- die Versorgungsniederspannung zu verstärken, um eine erste Sperrspannung (V_{BLOC1}) zu erzeugen, die strikt größer als die Versorgungsniederspannung ist; und
- die erste Sperrspannung an die ersten Bereiche (241) von Zellen (24B), die zu derselben Steuerleitung wie jene, die mit der zu programmierenden Zelle verbunden ist, gehören, über dritte Steuerleitungen (22), die diesen Zellen entsprechen, anzulegen.

10. Verfahren zum Programmieren einer Speicherzelle nach Anspruch 9, bei dem die Matrix durch eine Versorgungsquelle versorgt werden kann, die eine Versorgungsspannung besitzt, die größer als eine minimale Referenzspannung (V_{REF}) ist, wobei das Verfahren eine anfängliche Operation umfasst, die darin besteht:
- die Verstärkermittel (34; 42) ausschließlich für eine empfangene Versorgungsspannung zu aktivieren, die gleich der Referenzspannung ist.

11. Verfahren zum Programmieren einer Speicherzelle einer Matrix der Schaltung nach Anspruch 8, das insbesondere die Operationen umfasst, die darin bestehen:
- eine definierte Programmierspannung (V_{PROG}), die strikt kleiner als die Versorgungsspannung (V_{DD}) ist, an das Steuergate (245) der zu programmierenden Zelle (24A) über die dieser Zelle entsprechende erste Steuerleitung (18) anzulegen;
- eine zweite, negative Sperrspannung (-V_{BLOC2}) zu erzeugen;
- diese zweite, negative Sperrspannung an die Steuergates von Zellen (24C), die zu derselben dritten Steuerleitung (22) wie jene, die mit der zu programmierenden Zelle verbunden ist, gehören, über erste Steuerleitungen (18), die diesen Zellen entsprechen, anzulegen; und
- die Versorgungsniederspannung an die Zellen, die zu derselben ersten Steuerleitung wie die zu programmierende Zelle gehören, über die dritte Steuerleitung dieser Zellen anzulegen.
